(19)

Europäisches
Patentamt
European
Patent Office
Office européen
des brevets

(11) **EP 1 912 042 A2**

(12) **EUROPEAN PATENT APPLICATION**

(43) Date of publication:
**16.04.2008 Bulletin 2008/16**

(51) Int Cl.:
***G01C 19/56*** (2006.01)   *H03H 9/21* (2006.01)
*H03H 9/02* (2006.01)

(21) Application number: **07118402.2**

(22) Date of filing: **12.10.2007**

(84) Designated Contracting States:
**AT BE BG CH CY CZ DE DK EE ES FI FR GB GR HU IE IS IT LI LT LU LV MC MT NL PL PT RO SE SI SK TR**
Designated Extension States:
**AL BA HR MK RS**

(30) Priority: **13.10.2006 JP 2006279354**

(71) Applicants:
• **Fujitsu Media Devices Limited
Yokohama-shi,
Kanagawa 222-0033 (JP)**
• **FUJITSU LIMITED
Kawasaki-shi,
Kanagawa 211-8588 (JP)**

(72) Inventors:
• **Yamaji, Takayuki
c/o FUJITSU MEDIA DEVICES LIMITED
Yokohama-shi, Kanagawa 222-0033 (JP)**

• **Ishikawa, Hiroshi
c/o FUJITSU LIMITED
Kawasaki-shi, Kanagawa 211-8588 (JP)**
• **Takahashi, Yuji
c/o FUJITSU LIMITED
Kawasaki-shi, Kanagawa 211-8588 (JP)**
• **Katsuki, Takashi
c/o FUJITSU LIMITED
Kawasaki-shi, Kanagawa 211-8588 (JP)**
• **Nakazawa, Fumihiko
c/o FUJITSU LIMITED
Kawasaki-shi, Kanagawa 211-8588 (JP)**
• **Inoue, Hiroaki
c/o FUJITSU LIMITED
Kawasaki-shi, Kanagawa 211-8588 (JP)**

(74) Representative: **Fenlon, Christine Lesley
Haseltine Lake
5th Floor, Lincoln House
300 High Holborn
London WC1V 7JH (GB)**

(54) **Vibration sensor and method for manufacturing the same**

(57)    A vibration sensor includes a tuning-fork vibrator having a base and arms extending from the base, a mounting portion for mounting the tuning-fork vibrator, and a supporting member that mounts the tuning-fork vibrator on the mounting portion and has a narrow portion.

Fig. 1

EP 1 912 042 A2

**Description**

BACKGROUND OF THE INVENTION

1. Field of the Invention

The present invention relates to vibration sensors, and more particularly, to a vibration sensor having a tuning-fork vibrator. Further, the present invention relates to a method for manufacturing such as a vibration sensor.

2. Description of the Related Art

Vibration sensors such as acceleration sensors and angular velocity sensors have a vibration body. Vibrations of vibration body are sensed to thus detect acceleration and angular velocity. For example, the angular velocity sensors are used for car navigation systems and image stabilization in digital cameras. Japanese Patent Application Publication No. 2005-49306 discloses a vibration sensor in which a tuning-fork vibrator made of crystalline quartz is mounted to a substrate or a package by means of a single mounting piece, which may be a bump, solder, or electrically conductive adhesive.

A method for mounting the tuning-fork vibrator on the mounting portion is an important factor involved in improvements in the sensitivity of the vibration sensor. The above-mentioned application supports the tuning fork vibrator at a single point by using a bump, solder or conductive adhesive. However, the inventors found out that the above mounting method has a considerable difficulty in improvements of the temperature characteristic of the vibration sensor.

SUMMARY OF THE INVENTION

The present invention has been made in view of the above circumstances, and provides a vibration sensor having improved sensitivity.

According to an embodiment of an aspect of the present invention, there is provided a vibration sensor including: a tuning-fork vibrator having a base and arms extending from the base; a mounting portion for mounting the tuning-fork vibrator; and a supporting member that mounts the tuning-fork vibrator on the mounting portion and has a narrow portion.

According to an embodiment of another aspect of the present invention, there is provided a method of manufacturing a vibration sensor including: forming a bump to at least one of a base of a tuning-fork vibrator having multiple arms extending from the base and a mounting portion; and mounting the tuning-fork vibrator to the mounting portion through multiple bumps that are stacked and include said bump formed to said at least one of the base and the mounting portion.

BRIEF DESCRIPTION OF THE DRAWINGS

Preferred embodiments of the present invention will now be described with reference to the accompanying figures, in which:

Fig. 1 is a perspective view of an angular velocity sensor in accordance with a first embodiment of the present invention;
Fig. 2 is a perspective view of a tuning-fork vibrator;
Figs. 3A and 3B show electrode patterns formed on a front side of the tuning-fork vibrator;
Fig. 4A and 4B show vibration modes of the tuning-fork vibrator;
Fig. 5 shows a node line of the tuning-fork vibrator;
Fig. 6A is a plan view of a mounting portion;
Fig. 6B is a plan view of the mounting portion with the tuning-fork vibrator being mounted thereon;
Fig. 6C is a cross-sectional view taken along a line A-A shown in Fig. 6B;
Fig. 7 shows a backside of the turning-fork vibrator;
Figs. 8A through 8D show a method for mounting the tuning-fork vibrator;
Figs. 9A and 9B shows another method for mounting the tuning-fork vibrator;
Fig. 10 shows a first comparative example;
Fig. 11 shows impedance of the tuning-fork vibrators of the first embodiment and the first comparative example as a function of temperature;
Figs. 12A through 12C show exemplary backsides of the tuning-fork vibrator;
Figs. 13A and 13B show a method for mounting the tuning-fork vibrator;
Figs. 14A and 14B show another method for mounting the tuning-fork vibrator;
Figs. 15A and 15B show yet another method for mounting the tuning-fork vibrator;
Figs. 16A and 16B show a further method for mounting the tuning-fork vibrator; and
Figs. 17A and 17B show a still further method for mounting the tuning-fork vibrator;

DESCRIPTION OF THE PREFERED EMBODIMENTS

A description will now be given of embodiments of the present invention in conjunction with the accompanying drawings.

[First Embodiment]

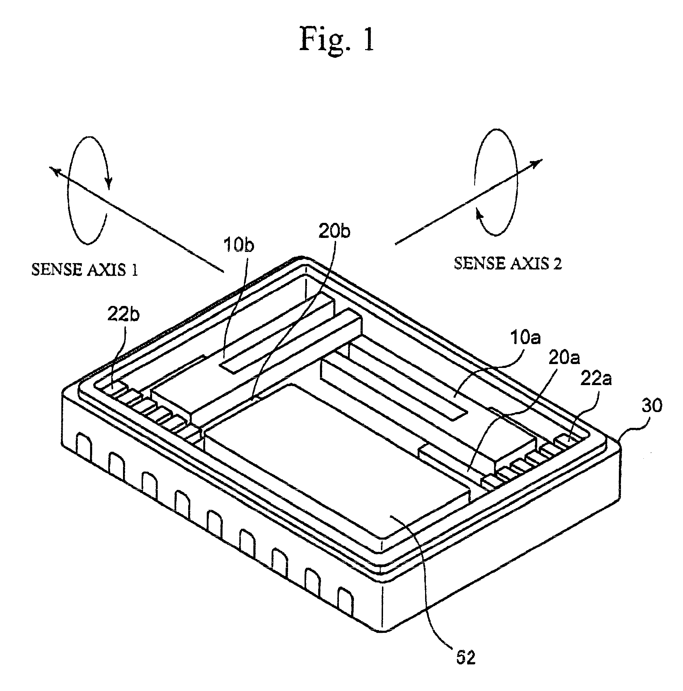

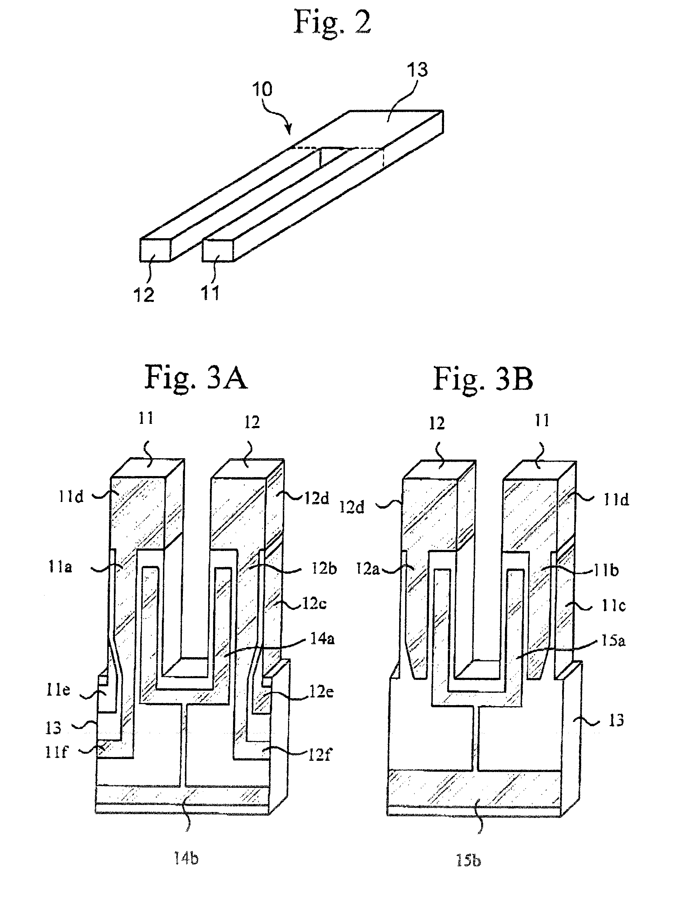

A first embodiment of the present invention is an exemplary angular velocity sensor in which two tuning-fork vibrators are mounted on a package. Fig. 1 is a perspective view of the present angular velocity sensor, and Fig. 2 is a perspective view of a tuning-fork vibrator. Referring to Fig. 1, two tuning-fork vibrators 10a and 10b are mounted on and fixed to mounting portions 20a and 20b of a cavity-type package 30, respectively. Each of the tuning-fork vibrators 10a and 10b has two arms. The mounting portions 20a and 20b are provided with bonding pads 22a and 22b, respectively. In Fig. 1, there are omitted electrodes of the tuning-fork vibrators 10a and 10b and bonding wires which connect the vibrators 10a and 10b and the pads 22a and 22b for the sake of simplicity. The vibrators 10a and 10b are oriented in mutually perpendicular directions, and have sense axes 1 and 2 in the respective longitudinal directions. The vibrators 10a and 10b are capable of sensing angular velocities about the sense axes 1 and 2, respectively. A control circuit 52, which has a board on which electronic components are mounted, is mounted on the package 30. The control circuit 52 controls the vibrators 10a and 10b. More specifically, the control circuit 52 supplies the tuning-fork vibrators 10a and 10b with drive signals, and receives sense signals therefrom. The package 30 is sealed with a cap (not shown).

Referring to Fig. 2, a tuning-fork vibrator 10, which may be each of the vibrators 10a and 10b, has a base 13 and two (multiple) arms 11 and 12 extending from the base 13. The tuning-fork vibrator 10 is made of a piezoelectric material such as lithium niobate ($LiNbO_3$) or lithium tantalate ($LiTaO_3$). When $LiNbO_3$ or $LiTaO_3$ is used, a 130° to 140° Y-cut plate may be used in order to obtain a high k23 electromechanical coupling coefficient. An electrode pattern (not illustrated for the sake of simplicity) formed by a metal film made of gold (Au), aluminum (Al) or copper (Cu) is formed on the surfaces of the tuning-fork vibrator 10.

Fig. 3A shows an electrode pattern on the front side of the tuning-fork vibrator 10, and Fig. 3B shows an electrode pattern on the back side thereof. The arm 11 is provided with sense electrodes 11a, 11b and 11c. The sense electrodes 11a and 11b are connected through an electrode 11d. An extraction electrode 11f is connected to the sense electrode 11a. The electrode 11c is connected to an extraction electrode 11e. Similarly, the arm 12 is provided with sense electrodes 12a, 12b and 12c. The sense electrodes 12a and 12b are connected through an electrode 12d. An electrode 12f is connected to the sense electrode 12a. The sense electrode 12c is connected to an extraction electrode 12e. A drive electrode 14a is provided on the front surface of the tuning-fork vibrator 10, and is connected to an extraction electrode 14b. Similarly, a drive electrode 15a is provided on the back surface of the tuning-fork vibrator 10, and is connected to an extraction electrode 15b.

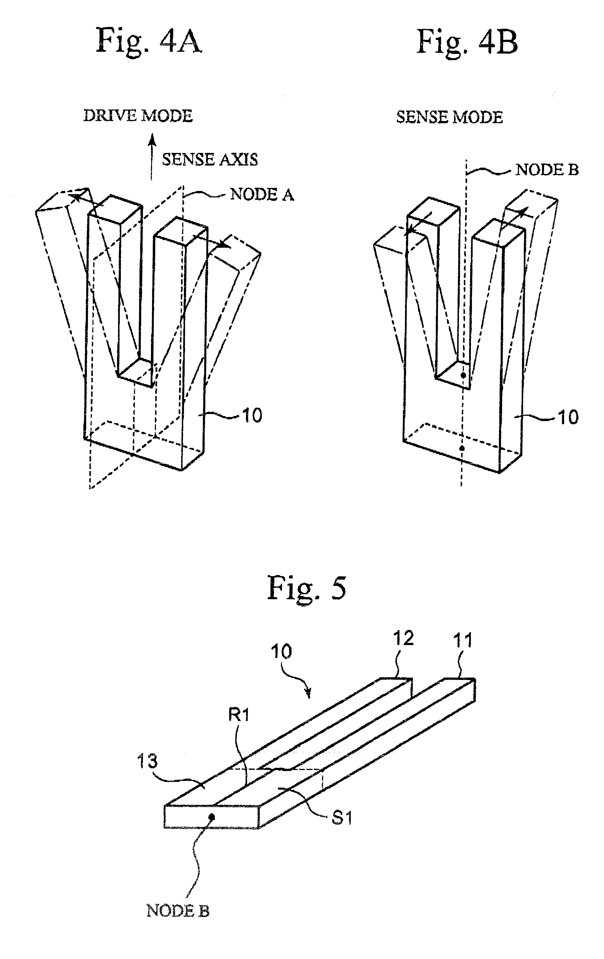

Figs. 4A and 4B show a drive mode and a sense mode, respectively. Referring to Fig. 4A, a drive signal is applied between the drive electrodes 14a and 15a to cause a vibration mode in which the arms 11 and 12 move close to and away from each other in turn. The vibration shown in Fig. 4A is parallel to a plane in which the arms 11 and 12 are included. This is called in-plane vibration mode. An angular velocity applied to the sense axis produces Coriolis force and causes another vibration mode shown in Fig. 4B in which the arms 11 and 12 move back and forth. This vibration is a twist vibration perpendicular to the plane on which the arms are vibrated. This is called plane-vertical vibration mode. The sense electrodes 11a, 11b and 11c and 12a, 12b and 12c sense the plane-vertical vibration mode, so that angular velocities about the sense axes 1 and 2 can be detected. The drive mode is a vibration mode for driving, and the sense mode is a vibration mode for sensing. A node is defined as a portion that does not vibrate in each of the drive and sense modes. In Fig. 3A, a symmetrical plane of the tuning-fork vibrator 10 is node A, and the center axis of the tuning-fork vibrator 10 is node B.

Fig. 5 shows the backside of the tuning-fork vibrator. A node line R1 of the base 13 is defined by projecting a node common to nodes A and node B (namely, node B) onto a surface S1 (on which a support portion is formed as will be described later).

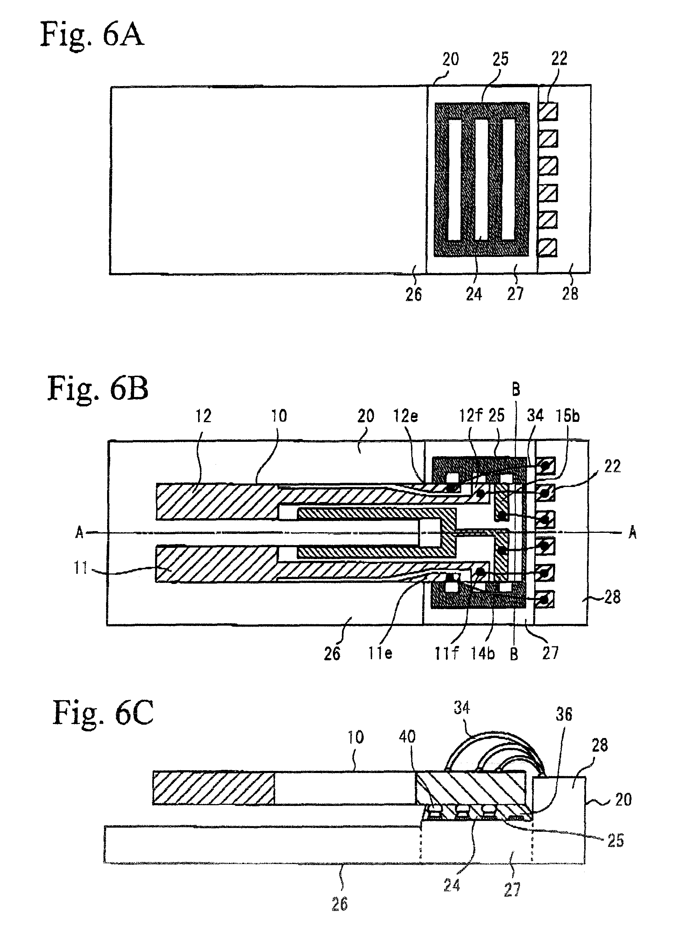

Fig. 6A is a plan view of the mounting portion 20, Fig. 6B is a plan view of the mounting portion 20 on which the tuning-fork vibrator 10 is mounted, and Fig. 6C is a cross-sectional view taken along a line A-A. Referring to Fig. 6A, the mounting portion 20 may be made of, for example, ceramic, and is composed of a bonding pad section 28, a vibrator supporting section 27, and a main body 26. Bonding wires 34 extending from the tuning-fork vibrator 10 are connected to the bonding pads 22. A pad 25 is provided in the vibrator supporting section 27, and is used to make a connection with the tuning-fork vibrator 10 using metal bumps functioning as supporting members 40. The pads 25 extend from a position just below the tuning-fork vibrator 10 to outsides thereof. The pad 25 has longitudinal recess portions 24 defined by adjacent longitudinal portions of the pad 25. There is no pad in the recess portions 24. The pads 22 and 25 may be formed by gold plating.

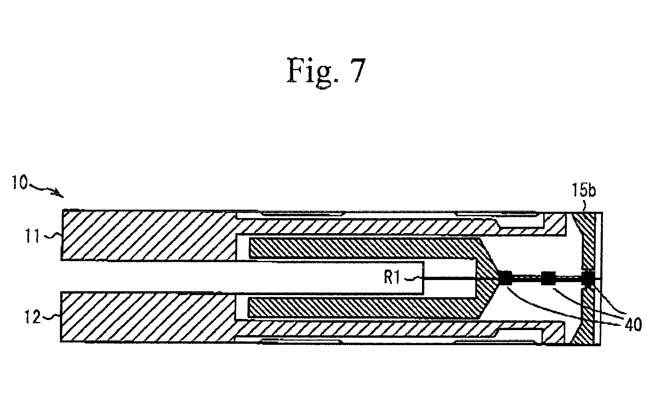

Referring to Fig. 6B, the bonding wires 34 make connection between the extraction electrodes 11e, 11f, 12e, 12f, 14b and 15b and the bonding pads 22. The control circuit 52 is connected to the bonding pads 22. A pattern of the extraction electrodes 14b and 15b is slightly different from the patterns shown in Figs. 3A and 3B for the convenience' sake. Referring to Fig. 6C, the upper surface of the wire pad section 28 is designed to approximately level the height of the tuning-fork vibrator 10 in order to make it easy to bond wires from the tuning-fork vibrator 10. The upper surface of the main body 26 is lower than the upper surface of the vibrator supporting section 27. The tuning-fork vibrator 10 is flip-chip mounted on the pad 25 by the supporting members 40 formed of, for example, gold bumps. A resin portion 36 is provided so as to cover the supporting members 40 for the purpose of reinforcement of mounting. The resin portion 36 may be adhesive made of silicon resin or epoxy resin. Fig. 7 shows the backside of the tuning-fork vibrator 10 having an exemplary arrangement in which three supporting members 40 are used.

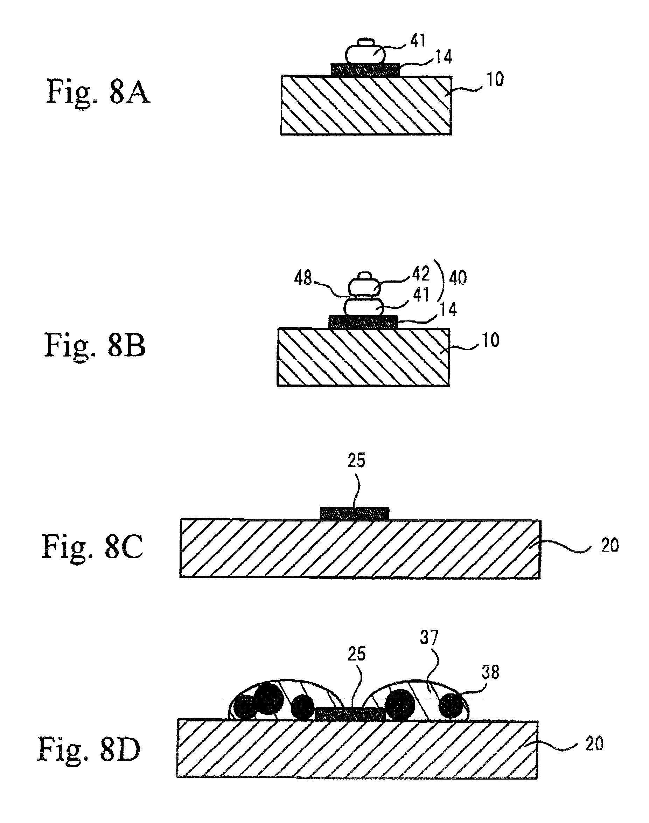

A description will now be given, with reference to Fig. 8A through 9B, of an exemplary method for mounting the tuning-fork vibrator 10 of the angular velocity sensor on the mounting portion 20 in accordance with the first embodiment. Referring to Fig. 8A, Au stud bumps 41 are formed on electrode pads 14 of the base of the tuning-fork vibrator 10 made of LiNbO$_3$. The stud bumps 41 have a diameter of approximately 100 $\mu$m and a height of approximately 60 $\mu$m. Referring to Fig. 8B, Au stud bumps 42 are formed on the bumps 41. The bumps 42 have a diameter that is smaller than that than the bumps 41 and may be approximately 80 $\mu$m in diameter. In the above manner, the bumps are stacked to thus form the supporting members 40 having a narrow or constricted portion 48. Referring to Fig. 8C, the mounting portion 20 equipped with the Au pad 25 formed by plating and composed of ceramic is mounted on a stage of a flip-chip bonder (not shown). Referring to Fig. 8D, a resin member 37 is coated on the mounting portion 20. The resin member 37 is made of thermoset epoxy resin containing fillers 38 having a major component of aluminum (Al).

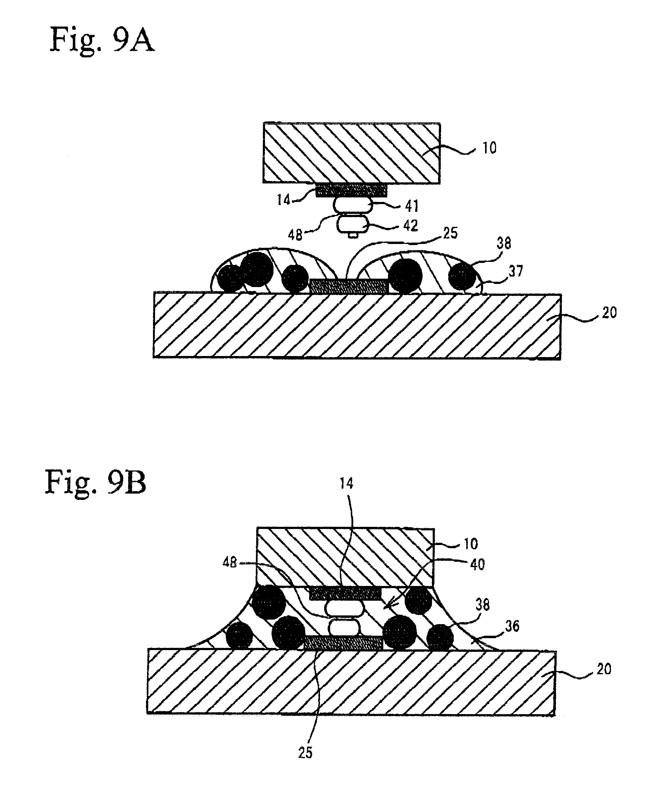

Referring to Fig. 9A, the tuning-fork vibrator 10 is sucked by a tool of the flip-chip bonder (not shown), and the supporting members 40 are positioned with respect to the pad 25 of the mounting portion 20. Referring to Fig. 9B, the supporting members 40 are flip-chip bonded to the pad 25. Then, the thermoset epoxy resin is cured to thus form the resin portion 36.

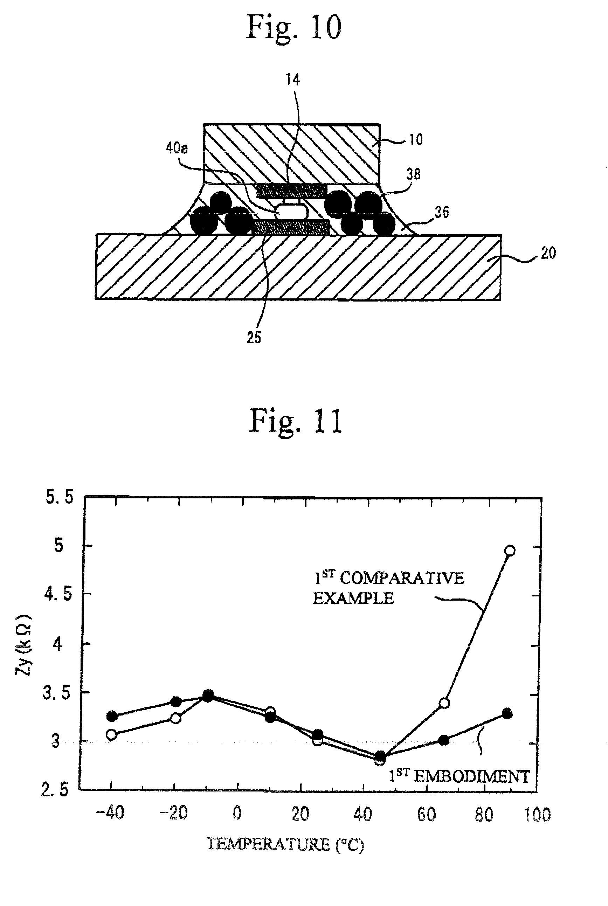

Referring to Fig. 10, there is illustrated a first comparative example, which is an angular velocity sensor having a support member 40a formed by a single stage of Au stud bumps, wherein the support member 40a has a diameter of approximately 100 $\mu$m and a height of approximately 60 $\mu$m. The other structures of the first comparative example are similar to those of the first embodiment shown in Fig. 9B.

Fig. 11 is a graph of impedance Zy (k$\Omega$) of the detection electrodes of the tuning-fork vibrators 10 of the first embodiment and the first comparative example as a function of temperature (°C). At temperatures equal to or lower than 45 °C, the impedance Zy of the first comparative example has almost the same values as those of the impedance Zy of the first embodiment. At temperatures equal to or higher than 65 °C, the impedance Zy of the first comparative example rises abruptly, whereas the impedance Zy of the first embodiment are approximately constant. At 90 °C, the first embodiment has an impedance Zy of approximately 3.3 k$\Omega$, whereas the first comparative example has an impedance of Zy as extremely high as approximately 5 k$\Omega$.

The sensitivity of the vibration sensor increases as the resonance sharpness Q increases, where Q is defined as follows:

$$Q = 1/4(4\pi ZC(fa - fr))$$

where Z is the impedance at the resonant frequency, C is a series capacitance, fa is the anti-resonance frequency, and fr is the resonance frequency. It can be seen from the above expression that Q increases and the sensitivity can be improved as Z decreases. Thus, the sensitivity of the sense electrode of the first comparative example is considerably degraded at high temperatures.

Turning to Fig. 4A again, the arms 11 and 12 mainly vibrate in the in-plane vibration mode (drive mode in the first embodiment), and the base 13 does not vibrate as much as that in the plane-vertical vibration mode (sense mode in the first embodiment). Thus, the impedance does not change greatly for the different methods for mounting the base 13. In contrast, twist vibration is caused in the arms 11 and 12, and thus, the base 13 vibrates in the twist vibration mode. Thus, the impedance changes greatly for the different methods for mounting the base 13.

The tuning-fork vibrator 10 is made of a piezoelectric material and a dielectric member, and has a great impedance value. In contrast, at the resonance frequency, the tuning-fork vibrator 10 vibrates and the impedance decreases. However, if the vibration of the tuning-fork vibrator 10 is prevented, the impedance will be increased. In the first comparative example, the impedance is increased due to the difference in thermal expansion coefficient between the tuning-fork vibrator 10 and the mounting portion 20. On the contrary, the narrow portion 48 between the bumps 41 and 42 of each supporting member 40 employed in the first embodiment functions to reduce stress caused by the difference in thermal expansion coefficient between the tuning-fork vibrator 10 and the mounting portion 20. It is thus possible to restrain increase in impedance.

Preferably, the supporting members 40 may be formed of multiple bumps that are stacked. It is thus possible to make it easy to form the supporting members 40 each having the narrow portion 48 between the stacked bumps 41 and 42. Further, the supporting members 40 composed of the stacked bumps 41 and 42 widen the distance between the tuning-fork vibrator 10 and the mounting portion 20, as compared to the supporting member composed of the single-stage bump of the first comparative example. Thus, even when the resin portion 36 is formed by resin having a high viscosity or resin having a large filler size, the occurrence of voids such as air bubbles can be suppressed, and resin can be coated evenly.

Preferably, the multiple bumps 41 and 42 have different sizes or diameters. For example, the bumps 42 having a diameter smaller than that of the bumps 41 may be stacked thereon, so that the bumps can be stacked stably and reliably.

The supporting members 40 function to electrically connect the tuning-fork vibrator 10 and the mounting portion 20. It is thus possible to reduce the number of bonding wires 34. The supporting members 40 may be varied so as to aim at making mechanical connections only.

Preferably, the resin portion 36 is provided between the tuning-fork vibrator 10 and the mounting portion 20. It is thus possible to reinforce the mounting of the tuning-fork vibrator 10 to the mounting portion 20. In this case, preferably, the height of the supporting members 40 is greater than the diameter of the fillers 38 of the resin portion 36. If the supporting members 40 are lower than the diameter of the fillers 38, the fillers 38 may fix the tuning-fork vibrator 10 and the mounting portion 20 to each other, and may prevent vibration of the tuning-fork vibrator 10. For metal fillers, an electric connection may be made between the tuning-fork vibrator 10 and the mounting portion 20, which are thus short-circuited. These problems may be solved by setting the height of the supporting members 40 greater than the average diameter of the fillers 38. More preferably, the height of the supporting members 40 is greater than the maximum diameter of the filters 38.

Preferably, the cross-section of the resin portion 36 perpendicular to the node B of the tuning-fork vibrator 10 has a shape that is approximately symmetrical to a plane that includes the node B and is perpendicular to the in-plane vibration plane of the tuning-fork vibrator 10. It is thus possible to restrain increase in leakage of vibration from the tuning-fork vibrator 10 to the mounting portion 20 and to improve resistance to external shock.

The bumps 41 and 42 may be made of solder, copper (Cu) or aluminum (Al) other than gold. The stud bumps may be replaced by bumps by plating.

[Second Embodiment]

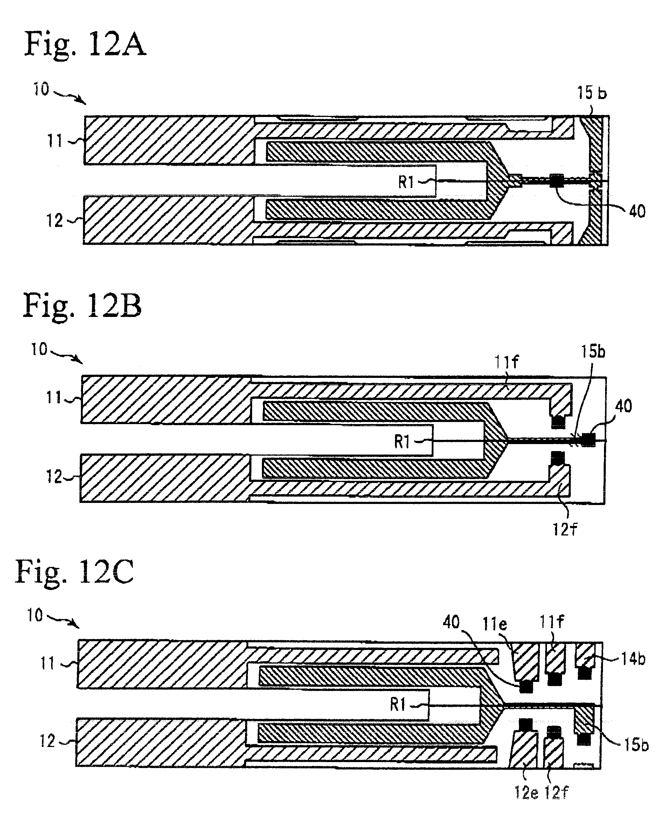

A second embodiment of the present invention differs from the first embodiment in which the supporting members 40 on the tuning-fork vibrator 10 are provided at different positions. As shown in Fig. 12A, when the tuning-fork vibrator 10 is supported by only one supporting member 40 provided on the node line R1, the node B may be easily vibrated in up and down directions with the supporting member 40 functioning as a supporting point. This may be considered as an increase in the impedance. When the multiple supporting members 40 on the node line R support the tuning-fork vibrator 10, as shown in Fig. 12B, the node B may have difficulty in vibration in the up and down directions. This may be considered as a decrease in the impedance.

Preferably, as shown in Figs. 7 and 12A, the supporting members 40 are provided on the node line R1. It is possible to restrain the up-and-down motion of the node B without affecting twist vibration in the plane-vertical vibration mode. The distance of the supporting members 40 may be shortened when the multiple supporting members 40 are used. However, it is preferable that the supporting members 40 are disposed at a comparatively long interval, as shown in Fig. 8B.

Figs. 12B and 12C respectively show exemplary arrangements in which some supporting members 40 are provided at positions that are not on the node line R in order to improve shock resistance. In order to secure the symmetry of vibration of the tuning-fork vibrator 10, the supporting members 40 are arranged symmetrically about the node line R1, as shown in Figs. 12B and 12C. In order to restrain the up-and-down motion of the node B, it is preferable to arrange some supporting members 40 at different positions in the direction of the node line R1.

[Third Embodiment]

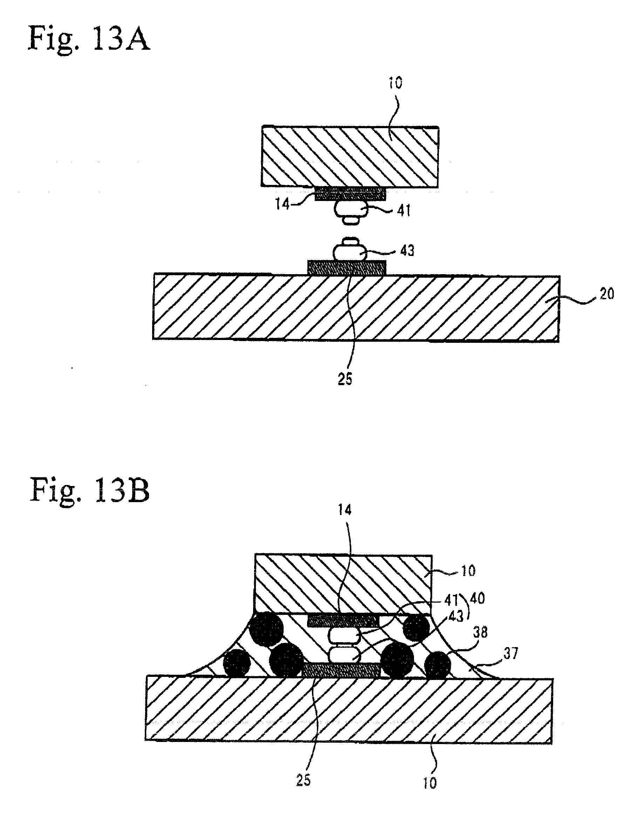

A third embodiment has an exemplary arrangement that employs a different method for forming bumps and a different number of bumps. Referring to Fig. 13A, the bump 41 is provided to the tuning-fork vibrator 10, and the bump 42 and a bump 43 is provided to the mounting portion 20. Then, as shown in Fig. 13B, the bumps 41 and 43 are joined together to form a support member 40b.

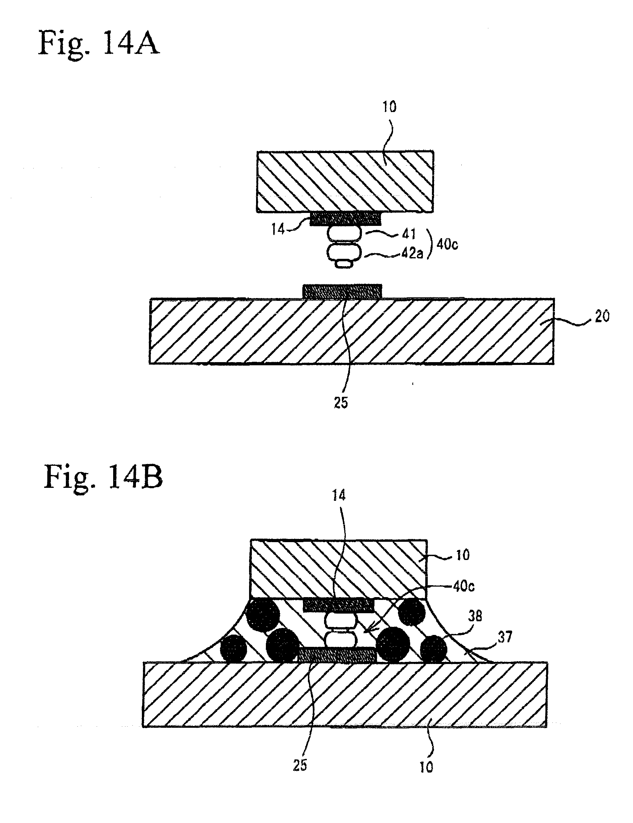

Referring to Fig. 14A, a bump 42a having the same size as the bump 41 is formed thereon. As shown in Fig. 14B, the bumps 41 and 42a are joined together to form a support member 40c.

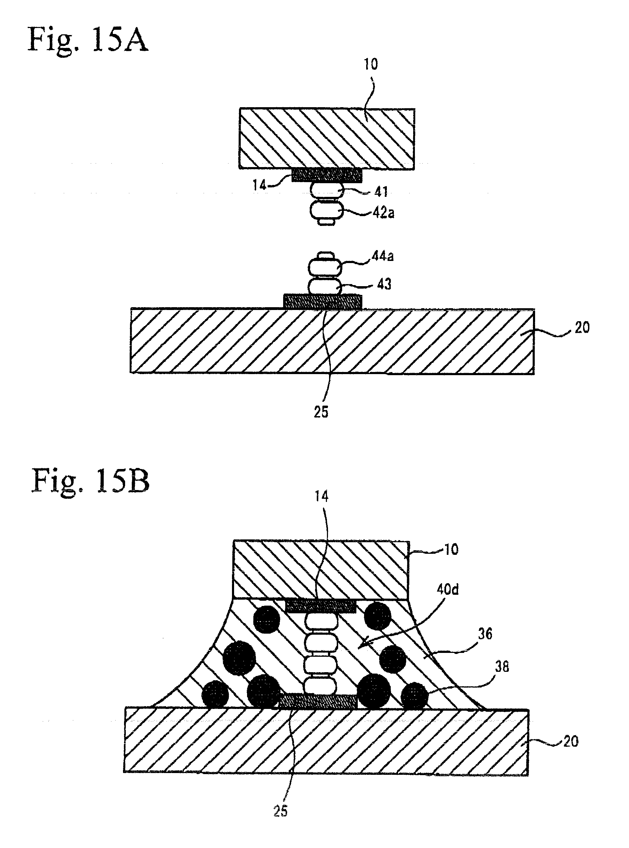

Referring to Fig. 15A, the bumps 41 and 42a are stacked and provided to the tuning-fork vibrator 10. The bumps 43 and 44a are stacked and provided to the mounting portion 20. Then, as shown in Fig. 15B, the bumps 42a and 44a are joined together to form a support member 40d.

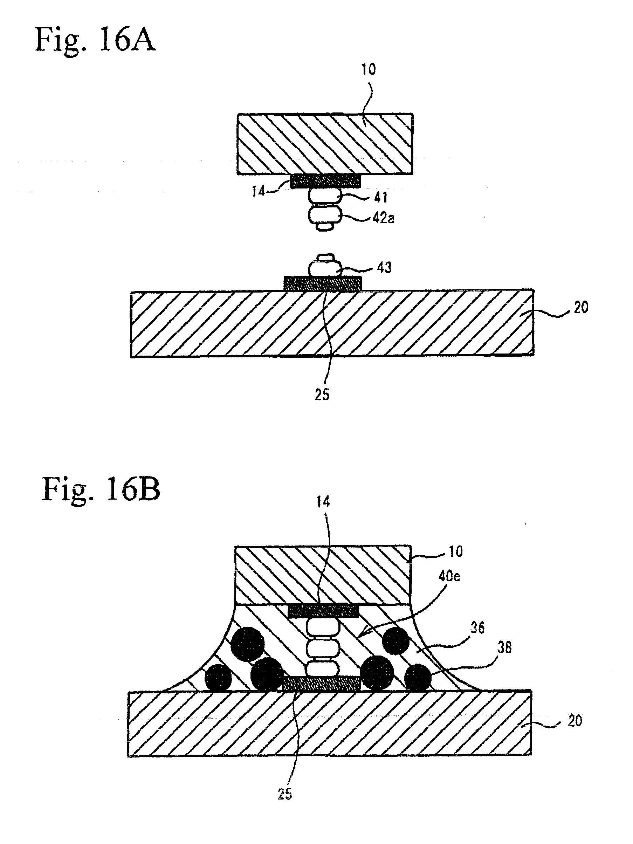

Referring to Fig. 16A, the bumps 41 and 42a are stacked and provided to the tuning-fork vibrator 10. The bump 42 is provided to the mounting portion 20. Then, as shown in Fig. 16B, the bumps 42a and 43 are joined together to form a support member 40e.

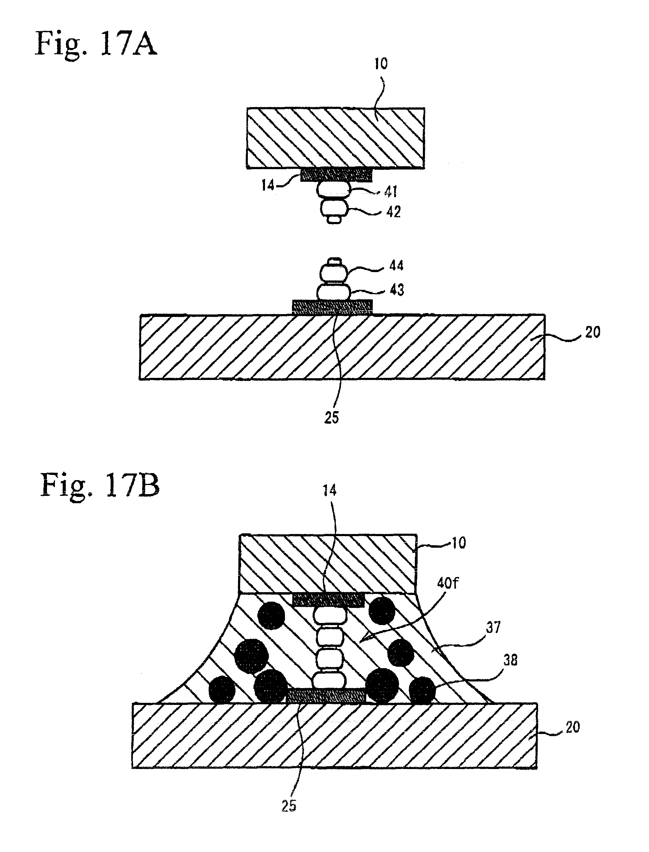

Referring to Fig. 17A, the bump 41 and the bump 42 having a smaller diameter than the bump 41 are stacked and provided to the tuning-fork vibrator 10. The bumps 43 and 44 are stacked and provided to the mounting portion 20. Then, as shown in Fig. 17B, the bumps 42 and 44 are joined together to form a support member 40f.

As shown in Fig. 8B, 13A, 14A, 15A, 16A and 17A, one or more bumps are provided to at least one of the base of the tuning-fork vibrator 10 and the mounting portion 20. Then, as shown in Figs. 9B, 13B, 14B, 15B, 16B and 17B, the tuning-fork vibrator 10 is mounted on the mounting portion 20 through a stack of the multiple bumps. It is thus possible to easily form the supporting members 40 having the narrow portions 48.

Preferably, the bumps may be stacked so that the currently formed bumps have a smaller diameter than the previously formed bumps, as shown in Figs. 9A and 17A. It is thus possible to easily stack the bumps.

The number of bumps to be stacked is equal to or greater than three as in the cases of Figs. 15B, 16B and 17B. In other words, the multiple narrow portions 48 may be provided to the supporting members 40.

The first through third embodiments employ the tuning-fork vibrator 10 having two arms 11 and 12. The present invention is not limited to two arms but may employ any tuning-fork vibrator having multiple arms. The foregoing description refers to the node B that is common to the in-plane vibration mode and the plane-vertical vibration mode. However, the common node B is not essential but it is enough to obtain at least one of nodes of the multiple vibration modes. The use of the common node B is more preferable. In the first through third embodiments, the mounting portion 20 is a part of the package 30 on which the tuning-fork vibrator 10 should be mounted. However, the mounting portion 20 is not limited to the above structure but is essential to have the function of mounting the tuning-fork vibrator 10. The mounting portion 20 may be a part of a mounting board on which the tuning-fork vibrator 10 should be mounted or may be a member other than the package 30 and the mounting board. The supporting members 40 have the function of holding the tuning-fork vibrator 10, and the resin portion 36 has the function of securing shock resistance. Thus, it is preferable that the resin portion 36 is softer than the supporting members 40. The first through third embodiments are vibration sensors, each having two tuning-fork vibrators 10. The present invention may include an arbitrary number of tuning-fork vibrators 10. The present invention includes not only the angular velocity sensors but also acceleration sensors.

The present invention is not limited to the specifically disclosed embodiments but other embodiments and variations may be made without departing from the scope of the present invention defined by the claims.

The present application is based on Japanese Patent Application No. 2006-279354 filed on October 13, 2006, the disclosure of which is hereby incorporated by reference.

**Claims**

1. A vibration sensor comprising:

   a tuning-fork vibrator having a base and arms extending from the base;
   a mounting portion for mounting the tuning-fork vibrator; and
   a supporting member that mounts the tuning-fork vibrator on the mounting portion and has a narrow portion.

2. The vibration sensor as claimed in claim 1, wherein the supporting member comprises multiple bumps stacked.

3. The vibration sensor as claimed in any preceding claim, wherein the supporting member comprises multiple bumps that are stacked and include different diameters.

4. The vibration sensor as claimed in any preceding claim, further comprising multiple supporting members, each being configured as said supporting member.

5. The vibration sensor as claimed in any preceding claim, wherein the supporting member electrically connects the tuning-fork vibrator and the mounting portion.

6. The vibration sensor as claimed in any preceding claim, the supporting member is provided on a node line defined by projecting a node onto a surface on which the supporting member is provided.

7. The vibration sensor as claimed in any preceding claim, wherein the supporting member is provided symmetrically about a node line defined by projecting a node onto a surface on which the supporting member is provided.

8. The vibration sensor as claimed in any preceding claim, further comprising a resin portion provided between the tuning-fork vibrator and the mounting portion.

9. The vibration sensor as claimed in claim 8, wherein the supporting member has a height greater than a size of fillers contained in the resin portion.

10. A method of manufacturing a vibration sensor, comprising the steps of:

    forming a bump to at least one of a base of a tuning-fork vibrator having multiple arms extending from the base and a mounting portion; and
    mounting the tuning-fork vibrator to the mounting portion through multiple bumps that are stacked and include said bump formed to said at least one of the base and the mounting portion.

11. The method as claimed in claim 10, wherein the step of forming the bump includes a step of stacking a second pump on a first bump, wherein the second bump has a smaller diameter than the first bump.

# Fig. 1

SENSE AXIS 1

SENSE AXIS 2

10b

20b

22b

10a

20a

22a

30

52

# Fig. 2

# Fig. 3A

# Fig. 3B

# Fig. 4A

DRIVE MODE

SENSE AXIS

NODE A

10

# Fig. 4B

SENSE MODE

NODE B

10

# Fig. 5

10

12

11

R1

13

S1

NODE B

Fig. 6A

Fig. 6B

Fig. 6C

# Fig. 7

Fig. 8A

Fig. 8B

Fig. 8C

Fig. 8D

Fig. 9A

Fig. 9B

# Fig. 10

# Fig. 11

## Fig. 12A

## Fig. 12B

## Fig. 12C

Fig. 13A

Fig. 13B

## Fig. 14A

## Fig. 14B

Fig. 15A

Fig. 15B

Fig. 16A

Fig. 16B

Fig. 17A

Fig. 17B

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2005049306 A
- JP 2006279354 A